# EUROPÄISCHE PATENTANMELDUNG

(11) **EP 2 955 646 A1**
(43) Veröffentlichungstag der Anmeldung: **16.12.2015**
(21) Anmeldenummer: 14171849.4
(22) Anmeldetag: 10.06.2014
(51) Int. Cl.: G06F 17/50

(54) **Verfahren und System zur Herstellung von Rahmen für Bilder**

(71) Anmelder: motiondrive AG, 92660 Neustadt a.d. Waldnaab (DE)
(72) Erfinder: Krachtus, Werner, 92660 Neustadt a. d. Waldnaab (DE)
(74) Vertreter: Lermer, Christoph

(57) **Zusammenfassung**

Ein System 1 zur Konfiguration eines Bilderahmens für ein Bild 2 gemäß der vorliegenden Erfindung weist eine Digitalisierungseinrichtung 3 mit ausreichend großem Scanfeld 30, einen Touchscreen-Monitor 4 und eine Datenverarbeitungseinrichtung 5 auf. In der Datenbank 53 der Datenverarbeitungseinrichtung 5 sind Grundrahmen bzw. Grundrahmenelemente, z.B. Rahmenleisten 20a, 20b, 20c, 20d und Passepartouts 21a, 21b hinterlegt. Aus diesen Grundrahmen(elementen) kann der Benutzer des Touchscreen-Monitors 4 eine Auswahl treffen und diese Auswahl durch Betätigung des Touchscreens bearbeiten

## Beschreibung

### TECHNISCHES GEBIET

Die Erfindung betrifft ein Verfahren zur Herstellung eines individuellen Rahmens für ein Bild und ein System zur Herstellung eines individuellen Rahmens für ein Bild, insbesondere zur Durchführung des genannten Verfahrens.

### STAND DER TECHNIK

Bei der Herstellung individueller Bilderrahmen findet die Auswahl und Konfiguration in der Regel in einem Rahmengeschäft statt. Zunächst wird das Bild vermessen. Anschließend wird ein Rahmen aus einer vorgegebenen Auswahl, z.B. aus einem Katalog, ausgewählt. Der ausgewählte Rahmen wird später anhand der Abmessungen des Bilds, beispielsweise in einem Herstellungsbetrieb für Bilderrahmen, individuell zugeschnitten und die Einzelteile zusammengefügt.

Dieser Prozess bringt jedoch einige Probleme mit sich. Zum einen ist es dem Käufer des Rahmens nicht möglich, die sehr spezifische Kombination aus Bild und Rahmen bzw. Passepartout, u. ä., vor der Fertigstellung zu begutachten. Vielmehr ist er auf seine Vorstellungskraft angewiesen. Die Festlegung von Rahmenbreite, Passepartout-Auswahl, Positionierung, etc., beruht auf Vermutungen bzgl. des späteren Aussehens der Kombination aus Rahmen und Bild. Dies kann zu unbefriedigenden Ergebnissen führen und ist sehr zeitaufwändig.

Außerdem müssen die Baukomponenten, z.B. Rahmenteile und Verbindungen, zueinander passend ausgewählt werden. Dabei kann es zu Fehlern kommen.

Der Aufwand und die Kosten für die Herstellung können in der Regel während der Konfiguration des Rahmens nur geschätzt, aufwändig ausgerechnet oder nachträglich nach der Herstellung bestimmt werden.

Insgesamt ist die Konzipierung und Herstellung eines Rahmens für ein Bild eine Aufgabe, die große Vorstellungskraft, hohe Erfahrung beim Anbieter und relativ große Flexibilität bei der Beurteilung des Ergebnisses und der Kosten erfordert.

### AUFGABE DER ERFINDUNG

Ausgehend davon besteht die Aufgabe der vorliegenden Erfindung darin, den Entwurfs- und Herstellungsprozess für Bilderrahmen zu vereinfachen und eine möglichst sichere Planung des Endergebnisses zu ermöglichen.

### TECHNISCHE LÖSUNG

Diese Aufgabe wird gelöst durch ein Verfahren zur Herstellung eines Rahmens für ein Bild, umfassend die Schritte: a) Digitalisieren des Bildes bzw. Einlesen digitaler Bilddaten; b) Anzeige des digitalisierten Bildes durch ein interaktives Bilddarstellungssystem; c) Auswahl eines Rahmens bzw. wenigstens eines Rahmenelements aus einer Datenbank und Hinzufügen der digitalisierten Abbildung des Rahmens bzw. der Rahmenelemente im Bilddarstellungssystem; d) Konfiguration/Bearbeitung des Rahmens bzw. der Rahmenelemente durch Positionieren der digitalisierten Abbildung des Rahmens relativ zum digitalisierten Bild, durch Änderung der Eigenschaften des Rahmens bzw. der Rahmenelemente wie Farbe, Größe, Breite, Positionierung des Rahmens bzw. der Rahmenelemente mittels eines Gestenerkennungssystems; und e) nach Abschluss des Schritts d) Erstellung eines Bauplans und/oder einer Stückliste für den Rahmen aus den Daten des konfigurierten Rahmens bzw. der konfigurierten Rahmenelemente.

Zum Digitalisieren des zu rahmenden Bilds ist insbesondere eine Digitalisierungseinheit vorgesehen, beispielsweise eine Einrichtung mit digitaler Kamera oder eine Scaneinrichtung zu Scannen des Bilds. Die Größe der Digitalisierungseinheit sollte ausreichend sein, um auch große Formate von Bildern, wie 1m x 2m, vollständig digitalisieren zu können.

Bilddarstellungs- und Gestenerkennungssystem können getrennte oder einheitlich konzipierte Systeme sein. Das Bilddarstellungssystem stellt das Bild bzw. Bilder und Rahmen bzw. Rahmenelemente visuell dar. Es kann insbesondere als Monitor oder Projektor zur Projektion eines Gegenstands sein.

Meist im Gestenerkennungssystem, aber potentiell auch separat davon, ist ein Gestenerfassungs-und ein Gestenverarbeitungssystem vorgesehen. Das Gestenerfassungssystem ist Teil des Gestenerkennungssystems. Die Begriffe können auch ausgetauscht werden, je nachdem welche der Funktionen "Erfassung" bzw. "Erkennung" herausgehoben werden soll. Das "Gestenerfassungssystem" könnte demnach durchgehend als "Gestenerfassungs und/oder-erkennungssystem" bezeichnet werden.

Im Gestenverarbeitungssystem ist eine Anzahl von Gesten hinterlegt, denen wiederum ein Bearbeitungsalgorithmus zur Bearbeitung der Bilddaten zugeordnet ist. Wird eine bestimmte Geste in einem bestimmten Bildbereich vom Gestenerkennungssystem detektiert (und ggf. auch erkannt), so sendet das Gestenerkennungssystem einen oder mehrere Befehle an das Gestenverarbeitungssystem, das dann die entsprechenden, der Geste zugeordneten Bilddatenverarbeitungsschritte durchführt. Entsprechend wird durch das Bilddarstellungssystem das durch das Bildverarbeitungssystem erzeugte / berechnete Bild dargestellt. Dieser Vorgang wird bis zur Erstellung und Festlegung eines Bilddatensatzes wiederholt, der der endgültig vom Benutzer gewünschten Kombination aus Bild und Rahmen(-elementen) entspricht. Zusammenfassend erkennt das Gestenerkennungssystem insbesondere mit der Hand oder den Händen durch den Benutzer in einem ersten bestimmten Bildbereich ausgeführte Gesten und führt dann eine vorprogrammierte Veränderung der Bilddaten - möglicherweise beschränkt auf einen zweiten Bildbereich (der dem ersten Bildbereich entsprechen kann) - und schließlich der Bilddarstellung am Bilddarstellungssystem durch, z.B. ein Verschieben, Drehen, Vergrößern, etc., eines oder mehrerer Bildelemente durch.

Das Gestenerkennungssystem kann jedes beliebige System sein, das vom Benutzer durchgeführte Gesten erkennt, z.B. ein Touchscreen oder ein Kamerasystem, das im Bereich eines dargestellten Bilds ausgeführte Gesten erfasst, erkennt, und einem bestimmten Bildbereich sowie einem bestimmten (Satz von)Ausführungsbefehl(en) zuordnet. Die erkannte Geste wird detektiert und einem Veränderungsalgorithmus für die Bilddaten zugeordnet, z.B. einer quantitativ der Geste entsprechende Koordinatentransformation für ein bestimmtes Bildelement. Das Gestenverarbeitungssystem wird in erster Linie als Software bereitgestellt, die die empfangenen den erkannten Gesten zugeordneten Daten und Befehle in eine Veränderung der Bilddaten umsetzt.

Das Bilddarstellungssystem kann beispielsweise ein Monitor sein, der zusammen mit dem Gestenerkennungssystem, z.B. einem Touchscreen, einen Touchscreen-Monitor bildet. Das Bilddarstellungssystem ist jedoch nicht auf einen Monitor beschränkt, sondern kann z.B. auch ein Projektionssystem (z.B. Beamer, Projektor) sein, das ein Bild an eine Wand oder Leinwand wirft. Auch hier kann ein Touchscreen dem Bild überlagert sein, d.h. der Touchscreen liegt unterhalb des projizierten Bilds. Es kann jedoch alternativ oder zusätzlich dazu beispielsweise ein Gestenerkennungssystem eingesetzt werden, das die Gesten und deren Position bezüglich der Bilddarstellung über Kameras erfasst und an das Gestenverarbeitungssystem überträgt. In wieweit die durch das Gestenerkennungssystem erfassten Daten bei der Übertragung bereits (vor-)verarbeitet sind, hängt lediglich von der Implementierung des Systems ab.

Insbesondere kann das Bilddarstellungssystem ein Monitor oder ein Projektionssystem sein.

Vorzugsweise kann das Gestenerkennungssystem ein Touchscreen oder ein Kamerasystem umfassend eine oder mehrere Kameras zur Aufnahme und / oder Detektion von im Bildbereich durch den Benutzer ausgeführten Gesten, insbesondere Handgesten, sein.

Insbesondere ist das Gestenerkennungs- und Bilddarstellungssystem ein Touchscreen-Monitor. Dieser ist an die Anwendung angepasst. Insbesondere kann er so groß sein, dass das Bild in Originalgröße (1:1) angezeigt wird. Dies ermöglicht eine 1:1 Anpassung des ausgewählten Rahmens bzw. der ausgewählten Rahmenelemente durch Betätigung des Touchscreens. Rahmen können durch geeignete Auswahl von Rahmenleisten aus einer Datenbank zusammengestellt werden. Weitere Rahmenelemente sind z.B. geeignete Verbindungsmittel, Passepartouts, Glas, Abdeckungen, etc.

Die im Rahmen des Verfahrens einsetzbaren Touchscreen-Monitore sind prinzipiell bekannt. Sie bestehen im Wesentlichen aus einem Touchscreen zur Erkennung von Berührungs-BewegungsMustern (Gesten) und einem Monitor, der die aus den Bewegungsmustern berechneten Ergebnisse anzeigt. Für eine Anzeige unterschiedlicher Bilder in Originalgröße sollte jedoch der Monitor eine gewisse Mindestgröße aufweisen. Er kann z.B. als 1m x 2m Multitouch-Monitor ausgebildet sein. Ein Multi-Touch-Screen ist definitionsgemäß ein Bildschirm mit Mehrfingergestenerkennung, der eine berührungsempfindliche Oberfläche für die Eingabe von Daten aufweist. Der Touchscreen-Monitor kann Berührungen kapazitiv oder optisch erfassen. Bildschirm (Monitor) und Multi-Touch-Screen sind zu einem Touch-Screen-Monitor kombiniert und liegen vorzugsweise übereinander.

Die Rahmenkonstruktion, die dem konfigurierten Rahmen und den konfigurierten Rahmenelementen entspricht, wird von einem entsprechenden Datenverarbeitungsprogramm berechnet und angezeigt. Insbesondere werden wenigstens einzelne im Schritt d) durchgeführte Anpassungen bzw. Änderungen des Rahmens und/oder der Rahmenelemente, z.B. der Größe und/oder Position, durch Erfassung einer Geste durch das Gestenerkennungssystem durchgeführt. So ist ein Größerziehen und/oder Verbreitern des Rahmens möglich. Der Preis des Rahmens verändert sich je nach Konfiguration der Rahmenkonfiguration und wird je nach aktueller Konfiguration angezeigt.

Beispielsweise kann eine Änderung der Größe des Rahmens bzw. eines Rahmenelements durch eine Touchscreen-Betätigung und/oder eine entsprechende Geste quer oder senkrecht zur einem Randabgrenzung des angezeigten Rahmens bzw. Rahmenelements durchführbar sein.

Eine Änderung der Position des angezeigten Rahmens bzw. eines angezeigten Rahmenelements und/oder des digitalisierten Bilds kann durch eine Touchscreen-Betätigung im Bereich des abgebildeten Gegenstands entlang einer gewünschten Verschieberichtung des abgebildeten Gegenstands durchführbar sein. Ist beispielsweise der Touchscreen als Multi-Touch-Screen ausgebildet, so werden die Mehrfingergesten erkannt und Anpassungen des Rahmens bzw. der Rahmenelemente an das Bild können entsprechend der Programmierung der Gestenerkennung vorgenommen werden.

Das Verfahren umfasst vorzugsweise einen weiteren Schritt f) Übermittlung (vorzugsweise elektronisch) einer Stückliste bzw. eines Bauplans an einen Rahmenhersteller. Stückliste bzw. Bauplan werden wenigstens zum Abschluss des Anpassungs-/Konfigurationsprozesses von einer Datenverarbeitungseinrichtung auf Basis der verwendeten Elemente und deren Konfiguration wie Größe, etc., berechnet. In einer besonders bevorzugten Ausführungsform werden Bauplan und/oder Stückliste während der Durchführung des Verfahrens stets aktualisiert, d.h. zumindest nach einer Veränderung der Rahmenkonfiguration neu berechnet.

Das Verfahren kann außerdem umfassen: eine vorzugsweise simultan zu den Verfahrensschritten c) und/oder d) oder während der Durchführung diese Verfahrensschritte ermittelte Preisbestimmung des aktuell konfigurierten und angezeigten Rahmens bzw. der aktuell konfigurierten und angezeigten Rahmenelemente, abhängig von der Auswahl und aktuellen Konfiguration des Rahmens bzw. der Rahmenelemente. Eine Neuberechnung kann in zeitlichen Abständen oder nach jeder Veränderung der Rahmenkonfiguration durchgeführt werden. So wird stets der aktuelle Preis einer Konfiguration berechnet und ggf. angezeigt.

Die Anzeige des digitalisierten Bilds durch das Bilddarstellungssystem im Schritt a) erfolgt insbesondere in Originalgröße oder in einer maßstabsgetreuen Vergrößerung oder Verkleinerung. Auf diese Weise ist eine reale Vorabansicht der Größe bzw. der Proportionen des Bilds und der Rahmenkonstruktion möglich.

Das Verfahren kann eine Berechnung und/oder Anzeige einer Stückliste für die aktuell angezeigte bzw. eine festgelegte Rahmenkonstruktion und/oder einen Bauplan für eine aktuell angezeigte bzw. eine festgelegte Rahmenkonstruktion und/oder eine Preisangabe für eine aktuell angezeigte bzw. eine festgelegte Rahmenkonstruktion umfassen.

Außerdem wird die Aufgabe gelöst durch ein System zur Durchführung eines Verfahrens wie oben beschrieben.

Außerdem wird die Aufgabe gelöst durch ein System zur Herstellung eines Rahmens für ein Bild, insbesondere zur Durchführung eines Verfahrens wie oben beschrieben, umfassend:
a) Ein Gestenerkennungs- und Bilddarstellungssystem zur Anzeige eines digitalisierten Bilds und/oder einer Abbildung eines Rahmens bzw. von Rahmenelementen, wobei wenigstens der angezeigte Rahmen bzw. die angezeigten Rahmenelemente durcheine vom Gestenerkennungssystem erkannte Geste verschiebbar und/oder veränderbar sind;
b) Eine Datenverarbeitungseinrichtung umfassend wenigstens einen Prozessor, und
c) eine Datenbank, in der Grund-Rahmen bzw. Grund-Rahmenelementen hinterlegt sind; wobei
   die Datenverarbeitungseinrichtung dazu ausgebildet und eingerichtet ist, einen durch einen Benutzer mittels des Gestenerkennungs- und Bilddarstellungssystem konfigurierten Rahmen zu verarbeiten; und wobei die Datenverarbeitungseinrichtung ein Datenverarbeitungsprogramm aufweist, das aus dem mittels des Gestenerkennungssystems konfigurierten Rahmen bzw. Rahmenelementen eine Stückliste und/oder ein Bauplan und/oder eine Preisangabe berechnet und ausgibt.

Das System kann eine Digitalisierungseinheit zur Digitalisierung eines Bilds umfassen, beispielsweise eine Aufnahmeeinrichtung zur Herstellung einer digitalen Fotografie des Bilds (z.B. Fototisch) oder eine Scaneinrichtung zu Scannen des Bilds. Die Größe der Digitalisierungseinheit muss ausreichend sein, um auch große Formate wie z.B. 1m x 2m vollständig digitalisieren zu können.

In der Datenbank sind insbesondere Preislisten und/oder Stücklisten für mögliche Rahmen bzw. Rahmenelemente hinterlegt zur Berechnung und/oder Ausgabe einer Bauplans und/oder eines Preises der aktuell auf dem Monitor angezeigten Rahmenkonfiguration. Die Berechnungen und/oder Anzeigen können in diskreten Zeitabständen aktualisiert werden oder nach jeder Veränderung der aktuellen Rahmenkonfiguration durch Austausch von Rahmenelementen (z.B. Grundrahmenleisten, Grundpassepartouts,...) oder deren Veränderung/Anpassung durch Touchscreen-Betätigung bzw. eine vom System erfasste Geste. Die Datenbank kann in der Datenverarbeitungseinrichtung oder außerhalb derselben, beispielsweise in einem Speicher innerhalb eines Netzwerks (z.B. Internet), hinterlegt sein.

Die Datenverarbeitungseinrichtung ist vorzugsweise derart konfiguriert, dass bei Eingabe eines Befehls durch den Benutzer ein Verfahren nach einem der Ansprüche 1 bis 9 durchgeführt wird.

Insgesamt kann der sehr individuelle und u.U. kostspielige Prozess der Erstellung einer für ein bestimmtes Bild geeigneten Rahmenkonstruktion effizienter und präziser durchgeführt werden. Neben einer realen Vorausansicht des Endprodukts wird mittels im Rahmen der Konfiguration erstellter Baupläne und Stücklisten die Fertigung erheblich erleichtert.

Für alle im Zusammenhang mit dem Verfahren und / oder der Vorrichtung beschriebenen Merkmale soll einzeln und in beliebigen Kombinationen Schutz beansprucht werden.

### KURZE BESCHREIBUNG DER FIGUREN

Weitere Vorteile und Merkmale der Erfindung werden aus der Beschreibung bevorzugter Ausführungsbeispiele anhand der Figuren deutlich. Es zeigen:
- Figur 1: eine schematische Darstellung eines erfindungsgemäßen Systems;
- Figur 2: eine Darstellung einzelner Konfigurationsmöglichkeiten für Bilderrahmen im Zusammenhang mit dem erfindungsgemäßen System; und
- Figur 3: eine schematische Darstellung eines erfindungsgemäßen Verfahrens.

### DETAILLIERTE BESCHREIBUNG EINES BEVORZUGTEN AUSFÜHRUNGSBEISPIELS

In der folgenden Beschreibung wird ein Ausführungsbeispiel beschrieben, bei dem das Gestenerkennungs- und Bilddarstellungssystem ein Touchscreen-Monitor ist. Es sollen jedoch im Rahmen der Erfindung auch alle anderen denkbaren Gestenerkennungs- und Bilddarstellungssysteme eingeschlossen sein.

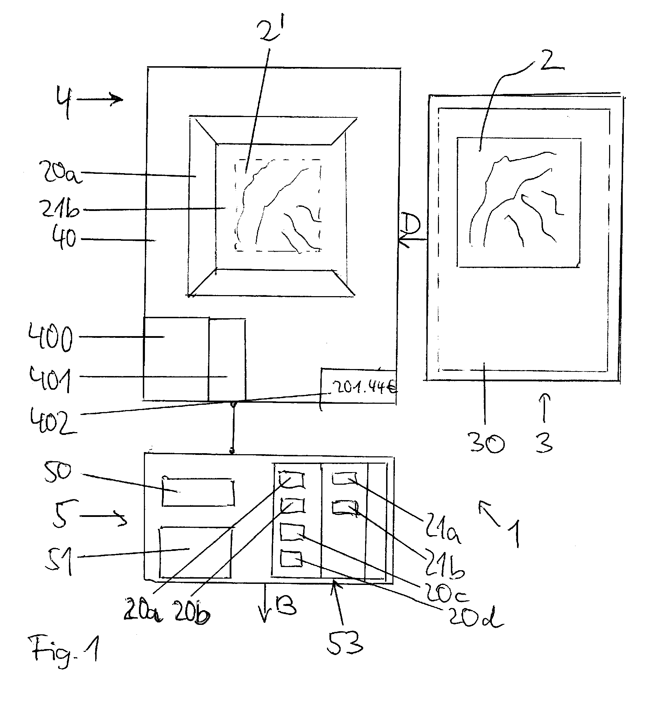

Die Figur 1 zeigt in schematischer Weise ein erfindungsgemäßes System 1 zur Konfiguration eines Bilderahmens für ein Bild 2.

Das Bild 2 ist insbesondere ein Kunstwerk oder eine Kopie eines Kunstwerks, also ein realer, physisch greifbarer Gegenstand. Das Bild wird in einer Digitalisierungseinrichtung, im vorliegenden Fall einem Scanner 3 mit ausreichend großem Scanfeld 30, erfasst. Die erfassten Daten werden in digitale Bilddaten konvertiert. Diese werden an einen Touchscreen-Monitor 4 übertragen (vgl. Pfeil D). Der Touchscreen-Monitor 4 weist übereinanderliegend eine Touchscreen-Einrichtung und einen Monitor 40 auf. Ein mittels der übertragenen Bilddaten erzeugtes Abbild 2' des Bilds 2 wird auf dem Monitor 40 in Originalgröße angezeigt. Zur Bedienung kann der Touchscreen-Monitor ein Feld 400 zur Eingabe von Befehlen aufweisen, z.B. ein Feld 400 mit Tastaturanzeige oder Auswahlfeldern für die Auswahl verschiedener Optionen. Außerdem besitzt der Monitor 40 Felder zur Anzeige weiterer Informationen zur aktuellen Rahmenkonfiguration, beispielsweise ein Feld 401 zur Anzeige einer Stückliste für die aktuelle Rahmenkonfiguration oder ein Feld 402 zur Anzeige des Preises der aktuellen Rahmenkonfiguration.

Das System weist außerdem eine Datenverarbeitungseinrichtung 5 auf, die mit dem Touchscreen-Monitor 4 verbunden ist (über Kabel oder drahtlos) und mit diesem Daten austauscht.

Die Datenverarbeitungseinrichtung 5 weist wenigstens einen Prozessor 50, einen Arbeitsspeicher 51 und eine Datenbank 53 (die natürlich im Arbeitsspeicher abgespeichert sein kann) auf. In der Datenbank 53 sind Grundrahmen bzw. Grundrahmenelemente, z.B. Rahmenleisten 20a, 20b, 20c, 20d und Passepartouts 21a, 21b hinterlegt. Die Datenbank kann selbstverständlich außerhalb der Datenverarbeitungseinrichtung hinterlegt sein, beispielsweise in einem Netzwerk (Internet) oder auf einem anderen dezentralen Rechner/Speicher.

Aus diesen Grundrahmen(elementen) kann der Benutzer des Touchscreen-Monitors 4, z.B. mittels Eingabe entsprechender Befehle im Feld 400, eine Auswahl treffen und diese Auswahl am Monitor 40 anzeigen lassen. Im vorliegenden Fall hat der Benutzer Element 20a als Rahmenleiste und Element 21b als Passepartout ausgewählt. Diese werden am Monitor 40 zusammen mit dem in Originalgröße angezeigten Bild 2' dargestellt. Die Anpassung der Position, Größe, Begrenzungen, etc., der Grundrahmen(elemente) 20a, 21b zu einer Rahmenkonfiguration 20a', 21b' kann durch Betätigung des Touchscreens durch den Benutzer erfolgen, wie später dargelegt werden wird.

Der Prozessor 50 errechnet aus den Anpassungen und Änderungen, die der Benutzer an den Rahmenelementen 20a, 21b durch Betätigung des Touchscreens vornimmt, nach jeder Veränderung oder in diskreten Zeitabständen eine aktuelle Stückliste und einen aktuellen Preis, welche in den Feldern 401 bzw. 402 des Monitors 40 angezeigt werden. Gleichzeitig oder nach Abschluss eines Konfigurationsvorgangs kann der Prozessor 50 einen Bauplan für die Rahmenkonfiguration 20a', 21b' berechnen. Bei Auftragserteilung wird dieser Bauplan, u.U. zusammen mit anderen Daten und/oder Preis und/oder Stückliste an den Rahmenhersteller übermittelt (dargestellt durch den Pfeil B). Der Bauplan kann selbstverständlich logistische Daten wie vorgesehene Fertigungsdauer o.ä. enthalten. Alle diese Daten können im Arbeitsspeicher 51 abgespeichert werden. Außerdem ist im Speicher 51 das Programm zur Steuerung des Systems abgespeichert.

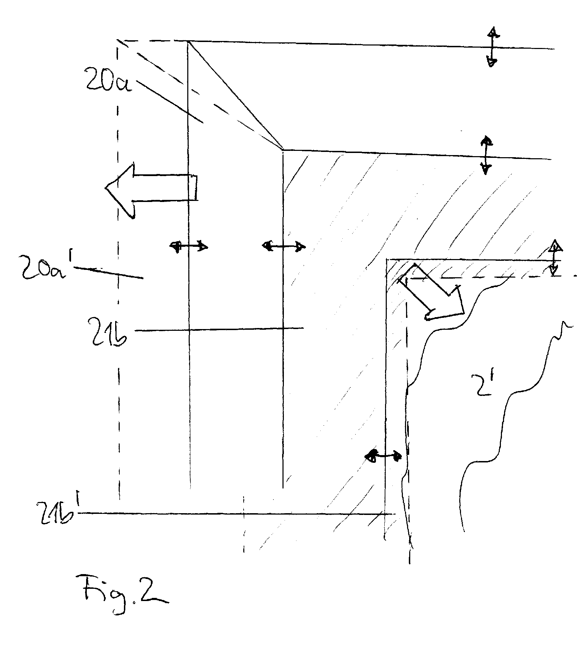

In der Figur 2 ist dargestellt, wie beispielsweise der Benutzer die angezeigten Rahmenelemente 20a, 21b durch Touchscreen-Bedienung an die Abbildung 2' des Bilds 2 anpassen kann.

So kann der Benutzer, durch Doppelpfeile an den Abgrenzungen der Rahmenleiste 20a die Abgrenzung nach innen oder außen verschieben, sodass der Rahmen breiter/schmäler und/oder insgesamt verschoben wird. Im Ausführungsbeispiel nach Figur 2 ist die Außenabgrenzung des Rahmenelements 20a nach außen verschoben, wobei die verschobene Außenabgrenze und ein breiterer Rahmen 20a' ergibt (angedeutet in Strichlinien). Das Passepartout 21b wurde, wie durch einen in der Ecke der Innenabgrenzung des Passepartouts 21b angedeuteten, nach innen weisenden Pfeil verdeutlicht, nach innen hin vergrößert, d.h. die obere und linke Abgrenzung der Bilddarstellung 2' wurde nach innen versetzt. Es ergibt sich das neue Passepartout 21b'.

Diese Möglichkeiten sind selbstverständlich nur beispielhaft. Alle für ein vorgegebenes Bild 2 sinnvollen und zugelassenen Auswahl- und Manipulationsmöglichkeiten an der Rahmenkonstruktion können mittels Touchscreen-Bedienung erzeugt und angezeigt werden, sodass der Benutzer unmittelbar eine direkte Visualisierung des Bilds mit Rahmenkonstruktion erhält. Zeitgleich können auf dem Monitor weitere Informationen betreffend die aktuelle Rahmenkonstruktion angezeigt werde wie der Preis, eine Stückliste, Herstellungsdauer, etc.

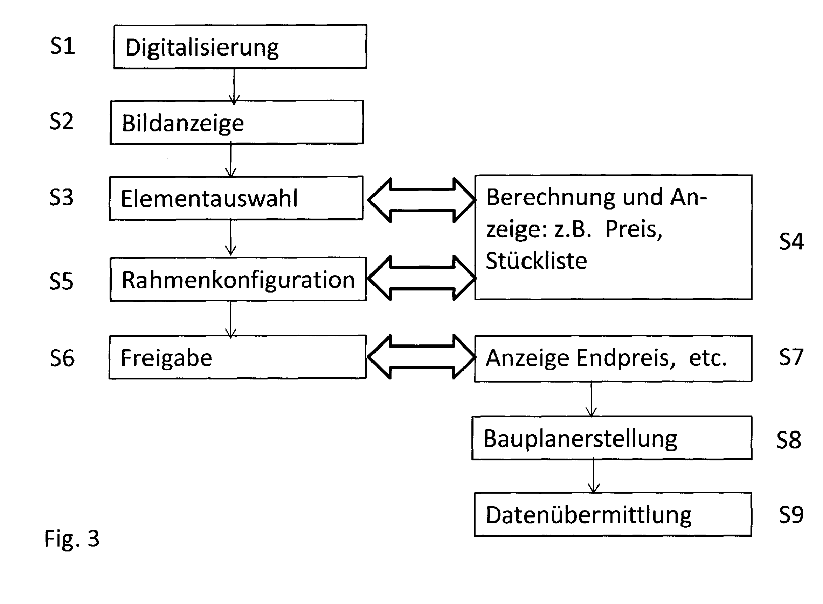

In der Figur 3 ist schematisch der Verfahrensablauf bei der Durchführung des Verfahrens gemäß der Erfindung illustriert.

Zunächst wird ein Bild, beispielsweise ein Gemälde, eingescannt oder auf andere Weise digitalisiert (z.B. durch digitale Fotografie; Schritt S1). Sofern das Bild bereits in digitaler Form vorliegt, entfällt dieser Schritt und die digitalen Bilddaten werden direkt weiter prozessiert.

Die Bilddaten werden ggf. verarbeitet und dann an einen Touchscreen-Monitor übermittelt, der das Bild, insbesondere in Originalgröße, anzeigt bzw. darstellt (Schritt S2). Anschließend wählt der Benutzer am Touchscreen Grund-Rahmenleisten und/oder Grund-Rahmenelemente aus, die in einer Datenbank hinterlegt sind (Schritt S3). Diese werden der Anzeige des Bilds auf dem Monitor hinzugefügt, sodass ein kombiniertes Abbild des Bilds zusammen mit den Rahmenelementen angezeigt wird.

Anschließend kann der Benutzer die ausgewählten und angezeigten Rahmenelemente durch Betätigung des Touchscreen konfigurieren, z.B. verschieben (relativ zum Bild), vergrößern, Abgrenzungen verschieben, verbreitern, verkleinern, Passpartoutgröße ändern, etc. (Schritt S5). Außerdem können Materialien, Farben, und andere Eigenschaften, soweit diese nicht durch die hinterlegten Grund-Rahmenelemente festgelegt sind, gewählt und beispielsweise durch entsprechende Befehle oder Auswahl entsprechender Menüoptionen, ausgewählt und verändert werden.

Nach bzw. während der Schritte S3 und S5 errechnet das System Parameter der aktuellen Auswahl und Konfiguration der Rahmenelemente und zeigt diese auf dem Touchscreen-Monitor an (Schritt S4). Der Doppelpfeil in Fig. 3 deutet an, dass die Daten vom Touchscreen-Monitors an einen Rechner übermittelt und weiter verarbeitet werden, andererseits die errechneten Daten an den Touchscreen-Monitor zur Anzeige derselben zurück übermittelt werden.

Ist die finale Version der Rahmenkonfiguration erstellt, kann diese durch einen entsprechenden Systembefehl freigegeben werden (Schritt S6).

Der Systembefehl kann unterschiedliche Verfahrensschritte auslösen, z.B. die Berechnung und Anzeige des Endpreises (Schritt S7), Bauplanberechnung und -erstellung (Schritt S8) und/oder Datenübermittlung z.B. des Bauplans an einen Rahmenhersteller (Schritt S9).

## Patentansprüche

1. Verfahren zur Herstellung eines Rahmens für ein Bild, **gekennzeichnet durch** die Schritte:
a) Digitalisieren des Bildes;
b) Anzeige des digitalisierten Bildes **durch** ein Bilddarstellungssystem;
c) Auswahl eines Rahmens bzw. wenigstens eines Rahmenelements aus einer Datenbank und Hinzufügen der digitalisierten Abbildung des Rahmens bzw. der Rahmenelemente in das **durch** das Bilddarstellungssystem dargestellte Bild;
d) Konfiguration/Bearbeitung des Rahmens bzw. der Rahmenelemente **durch** Positionieren der digitalisierten Abbildung des Rahmens relativ zum digitalisierten Bild, **durch** Änderung der Eigenschaften des Rahmens bzw. der Rahmenelemente wie Farbe, Größe, Breite, Positionierung des Rahmens bzw. der Rahmenelemente, insbesondere mittels eines Gestenerkennungssystems; und
e) Nach Abschluss des Schritts d) Erstellung eines Bauplans und/oder einer Stückliste für den Rahmen aus den Daten des konfigurierten Rahmens bzw. der konfigurierten Rahmenelemente.

2. Verfahren nach Anspruch 1, **dadurch gekennzeichnet, dass**
wenigstens einzelne im Schritt d) durchgeführte Anpassungen bzw. Änderungen des Rahmens und/oder der Rahmenelemente, z.B. der Größe und/oder Position, durch Betätigung des Touchscreens bzw. durch Erfassung einer Geste durch das Gestenerkennungssystem durchgeführt werden.

3. Verfahren nach Anspruch 1 oder 2, **dadurch gekennzeichnet, dass**
eine Änderung der Größe des angezeigten Rahmens bzw. eines angezeigten Rahmenelements durch eine Touchscreen-Betätigung bzw. eine entsprechende vom System erfasste Geste quer oder senkrecht zu einer Randbegrenzung des angezeigten Rahmens bzw. Rahmenelements durchführbar ist.

4. Verfahren nach einem der vorhergehenden Ansprüche, **dadurch gekennzeichnet, dass**
eine Änderung der Position des angezeigten Rahmens bzw. eines angezeigten Rahmenelements und/oder des digitalisierten Bilds durch eine Touchscreen-Betätigung bzw. Erfassung einer Geste durch das Gestenerkennungssystem im Bereich des abgebildeten Gegenstands entlang einer Verschieberichtung des abgebildeten Gegenstands durchführbar ist.

5. Verfahren nach einem der vorhergehenden Ansprüche, **dadurch gekennzeichnet, dass**
das Verfahren einen Schritt f) umfasst: Elektronische Übermittlung der Stückliste bzw. des Bauplans an einen Rahmenhersteller.

6. Verfahren nach einem der vorhergehenden Ansprüche, **dadurch gekennzeichnet, dass**
das Verfahren umfasst: eine Ermittlung des Preises des aktuell konfigurierten und angezeigten Rahmens bzw. der aktuell konfigurierten und angezeigten Rahmenelemente, abhängig von der Auswahl und aktuellen Konfiguration des Rahmens bzw. der Rahmenelemente.

7. Verfahren nach Anspruch 6, **dadurch gekennzeichnet, dass**
die Preisbestimmung simultan zu den Verfahrensschritten bzw. innerhalb der Verfahrensschritte c) und/oder d) durchgeführt wird.

8. Verfahren nach einem der vorhergehenden Ansprüche, **dadurch gekennzeichnet, dass**
die Anzeige des digitalisierten Bilds durch das Bilddarstellungssystem im Schritt a) in Originalgröße oder in einer maßstabsgetreuen Vergrößerung oder Verkleinerung erfolgt.

9. Verfahren nach einem der vorhergehenden Ansprüche, **dadurch gekennzeichnet, dass**
das Verfahren eine Berechnung und/oder Anzeige der Stückliste für die aktuell angezeigte bzw. eine festgelegte Rahmenkonstruktion und/oder des Bauplans für die aktuell angezeigte bzw. eine festgelegte Rahmenkonstruktion und/oder der Preisangabe für die aktuell angezeigte bzw. eine festgelegte Rahmenkonstruktion umfasst.

10. System zur Herstellung eines Rahmens für ein Bild, insbesondere zur Durchführung eines Verfahrens nach einem der vorhergehenden Ansprüche, umfassend:
a) Einen Bilddarstellungssystem zur Anzeige eines digitalisierten Bilds und/oder einer Abbildung eines Rahmens bzw. von Rahmenelementen, wobei wenigstens der angezeigte Rahmen bzw. die angezeigten Rahmenelemente durch Betätigung des Touchscreens bzw. eine entsprechende vom System erfasste Geste positionierbar und/oder veränderbar sind;
b) Eine Datenverarbeitungseinrichtung umfassend wenigstens einen Prozessor, und
c) eine Datenbank, in der Grund-Rahmen bzw. Grund-Rahmenelementen hinterlegt sind; wobei
die Datenverarbeitungseinrichtung dazu ausgebildet und eingerichtet ist, einen durch einen Benutzer mittels Betätigung des Touchscreens bzw. Erfassung einer entsprechenden Geste durch das System konfigurierten Rahmen zu bearbeiten; und wobei die Datenverarbeitungseinrichtung ein Datenverarbeitungsprogramm aufweist, das aus dem mittels Touchscreen-Betätigung bzw. Erfassung einer entsprechenden Geste durch das Gestenerkennungssystem konfigurierten Rahmen bzw. Rahmenelementen eine Stückliste und/oder ein Bauplan und/oder eine Preisangabe berechnet und ausgibt.

11. System nach Anspruch 10, **dadurch gekennzeichnet, dass**
das System eine Digitalisierungseinheit zur Digitalisierung eines Bilds umfasst.

12. System nach Anspruch 10 oder 11, **dadurch gekennzeichnet, dass**
das Bilddarstellungssystem ein Monitor oder ein Projektionssystem ist.

13. System nach einem der Ansprüche 10 bis 12, **dadurch gekennzeichnet, dass**
das Gestenerkennungssystem ein Touchscreen oder ein Kamerasystem ist.

14. System einem der Ansprüche 10 bis 13, **dadurch gekennzeichnet, dass**
in der Datenbank Preislisten und/oder Stücklisten für mögliche Rahmen bzw. Rahmenelemente hinterlegt sind zur Berechnung und/oder Ausgabe einer Bauplans und/oder eines Preises der aktuell auf dem Monitor angezeigten Rahmenkonfiguration.

15. System nach einem der Ansprüche 10 bis 14, **dadurch gekennzeichnet, dass**
die Datenverarbeitungseinrichtung derart konfiguriert ist, dass bei Eingabe eines Befehls durch den Benutzer ein Verfahren nach einem der Ansprüche 1 bis 9 durchgeführt wird.

## Geänderte Patentansprüche

### Geänderte Patentansprüche gemäss Regel 137(2) EPÜ.

1. Verfahren zur Herstellung eines Rahmens für ein Bild (2), **gekennzeichnet durch** die Schritte:
a) Digitalisieren (S1) des Bildes (2);
b) Anzeige (S2) des digitalisierten Bildes (2') **durch** ein Bilddarstellungssystem;
c) Auswahl (S3) eines Rahmens bzw. wenigstens eines Rahmenelements aus einer Datenbank und Hinzufügen einer digitalisierten Abbildung des Rahmens bzw. der Rahmenelemente (20 a-d, 21 a, b) in das **durch** das Bilddarstellungssystem dargestellte Bild (2');
d) Konfiguration und Bearbeitung (S5) des Rahmens bzw. der Rahmenelemente (20 a-d, 21 a, b) mittels eines Gestenerkennungssystems **durch** Positionieren der digitalisierten Abbildung des Rahmens relativ zum digitalisierten Bild (2') und **durch** Änderung der Eigenschaften des Rahmens bzw. der Rahmenelemente (20 a-d; 21 a, b) wie Größe, Breite, Positionierung des Rahmens bzw. der Rahmenelemente (20 a-d; 21 a, b); und
e) Nach Abschluss des Schritts d) Erstellung eines Bauplans (S8) und einer Stückliste (S4) für die Konstruktion des Rahmens aus den Daten des konfigurierten Rahmens bzw. der konfigurierten Rahmenelemente (20 a-d; 21 a, b).

2. Verfahren nach Anspruch 1, **dadurch gekennzeichnet, dass**
wenigstens einzelne im Schritt d) durchgeführte Anpassungen bzw. Änderungen des Rahmens und/oder der Rahmenelemente (20 a-d; 21 a, b), z.B. der Größe und/oder Position, durch Erfassung einer Geste durch das Gestenerkennungssystem durchgeführt werden.

3. Verfahren nach Anspruch 1 oder 2, **dadurch gekennzeichnet, dass**
eine Änderung der Größe des angezeigten Rahmens bzw. eines angezeigten Rahmenelements (20 a-d; 21 a, b) durch eine entsprechende vom Gestenerkennungssystem erfasste Geste quer oder senkrecht zu einer Randbegrenzung des angezeigten Rahmens bzw. Rahmenelements (20 a-d; 21 a, b) durchführbar ist.

4. Verfahren nach einem der vorhergehenden Ansprüche, **dadurch gekennzeichnet, dass**
eine Änderung der Position des angezeigten Rahmens bzw. eines angezeigten Rahmenelements (20 a-d; 21 a, b) und/oder des digitalisierten Bilds (2') durch eine Erfassung einer Geste durch das Gestenerkennungssystem im Bereich des abgebildeten Gegenstands entlang einer Verschieberichtung des abgebildeten Gegenstands durchführbar ist.

5. Verfahren nach einem der vorhergehenden Ansprüche, **dadurch gekennzeichnet, dass**
das Verfahren einen Schritt f) umfasst: Elektronische Übermittlung (S9) der Stückliste bzw. des Bauplans an einen Rahmenhersteller.

6. Verfahren nach einem der vorhergehenden Ansprüche, **dadurch gekennzeichnet, dass**
das Verfahren umfasst: eine Ermittlung des Preises (S4) des aktuell konfigurierten und angezeigten Rahmens bzw. der aktuell konfigurierten und angezeigten Rahmenelemente (20 a-d; 21 a, b), abhängig von der Auswahl und aktuellen Konfiguration des Rahmens bzw. der Rahmenelemente (20 a-d; 21 a, b).

7. Verfahren nach Anspruch 6, **dadurch gekennzeichnet, dass**
die Preisbestimmung (S4) simultan zu den Verfahrensschritten bzw. innerhalb der Verfahrensschritte c) und/oder d) durchgeführt wird.

8. Verfahren nach einem der vorhergehenden Ansprüche, **dadurch gekennzeichnet, dass**
die Anzeige des digitalisierten Bilds (2') durch das Bilddarstellungssystem im Schritt a) in Originalgröße oder in einer maßstabsgetreuen Vergrößerung oder Verkleinerung erfolgt.

9. Verfahren nach einem der vorhergehenden Ansprüche, **dadurch gekennzeichnet, dass**
das Verfahren eine Berechnung und/oder Anzeige der Stückliste (S4) für die aktuell angezeigte bzw. eine festgelegte Rahmenkonstruktion und/oder des Bauplans für die aktuell angezeigte bzw. eine festgelegte Rahmenkonstruktion und/oder der Preisangabe (S4, S7) für die aktuell angezeigte bzw. eine festgelegte Rahmenkonstruktion umfasst.

10. System zur Durchführung eines Verfahrens zur Herstellung eines Rahmens für ein Bild (2), nach einem der vorhergehenden Ansprüche, umfassend:
a) Einen Bilddarstellungssystem zur Anzeige eines digitalisierten Bilds (2') und einer Abbildung eines Rahmens bzw. von Rahmenelementen (20 a-d; 21 a, b), wobei wenigstens der ausgewählte und angezeigte Rahmen bzw. die angezeigten Rahmenelemente (20 a-d; 21 a, b) durch eine entsprechende von einem Gestenerkennungssystem erfasste Geste positionierbar und veränderbar sind;
b) Eine Datenverarbeitungseinrichtung (5) umfassend wenigstens einen Prozessor (50) und einen Speicher (51), wobei im Speicher (51) wenigstens eine Datenbank (53) mit GrundRahmen bzw. Grund-Rahmenelementen hinterlegt ist; wobei die Datenverarbeitungseinrichtung (5) dazu ausgebildet und eingerichtet ist, einen durch einen Benutzer mittels Erfassung einer entsprechenden Geste durch das Gestenerkennungssystem konfigurierten Rahmen zu bearbeiten; und wobei die Datenverarbeitungseinrichtung (5) ein Datenverarbeitungsprogramm aufweist, das aus dem Erfassung einer entsprechenden Geste durch das Gestenerkennungssystem konfigurierten Rahmen bzw. Rahmenelementen (20 a-d; 21 a, b) eine Stückliste und einen Bauplan und/oder eine Preisangabe berechnet und ausgibt.

11. System nach Anspruch 10, **dadurch gekennzeichnet, dass**
das System eine Digitalisierungseinheit zur Digitalisierung eines Bilds (2) umfasst.

12. System nach Anspruch 10 oder 11, **dadurch gekennzeichnet, dass**
das Bilddarstellungssystem ein Monitor(40) oder ein Projektionssystem ist.

13. System nach einem der Ansprüche 10 bis 12, **dadurch gekennzeichnet, dass**
das Gestenerkennungssystem ein Touchscreen oder ein Kamerasystem ist.

14. System einem der Ansprüche 10 bis 13, **dadurch gekennzeichnet, dass**
in der Datenbank (53) Preislisten und/oder Stücklisten für mögliche Rahmen bzw. Rahmenelemente (20a-d; 21 a, b) hinterlegt sind zur Berechnung und Ausgabe einer Bauplans und/oder eines Preises der aktuell auf dem Monitor (40) angezeigten Rahmenkonfiguration.

15. System nach einem der Ansprüche 10 bis 14, **dadurch gekennzeichnet, dass**
die Datenverarbeitungseinrichtung (5) derart konfiguriert ist, dass bei Eingabe eines Befehls durch den Benutzer ein Verfahren nach einem der Ansprüche 1 bis 9 durchgeführt wird.
